# EUROPEAN PATENT APPLICATION

(11) **EP 4 708 368 A1**
(43) Date of publication of application: **11.03.2026**
(21) Application number: 24797487.6
(22) Date of filing: 26.04.2024
(51) Int. Cl.: H01L 33/48, H01L 33/62, H01L 33/38, H01L 33/54, H01L 25/075

(54) **LIGHT-EMITTING MODULE AND DISPLAY DEVICE COMPRISING SAME**

(30) Priority: 28.04.2023 US 202363462548 P; 25.04.2024 US 202418645928
(71) Applicant: Seoul Viosys Co., Ltd., Ansan-si, Gyeonggi-do 15429 (KR)
(72) Inventor: KO, Mi So, Ansan-si Gyeonggi-do 15429 (KR); CHOI, Eun Mi, Ansan-si Gyeonggi-do 15429 (KR)
(74) Representative: Stolmár & Partner Patentanwälte PartG mbB
(86) International application number: PCT/KR2024/005725
(87) International publication number: WO 2024/225833

(57) **Abstract**

The present disclosure relates to a light emitting module and a display device including the same. In particular, there is provided a light emitting module, including: a module body including a base having an upper surface, a lower surface, and a plurality of peripheral surfaces connected to the upper surface and the lower surface; a plurality of electrodes disposed to be exposed to an outside on at least a part of the plurality of peripheral surfaces of the base ; a plurality of light emitting elements disposed on the base to be connected to two or more of the plurality of electrodes; and a molding covering the plurality of light emitting elements.

## Description

### TECHNICAL FIELD

The present disclosure relates to a light emitting module and a display device including the same.

### BACKGROUND ART

A display device is a device for displaying characters, symbols, images, or videos. The display device includes a plurality of light emitting modules, and the light emitting module includes a plurality of light emitting elements that emit light, and the plurality of light emitting elements may emit the same color or different colors. The display device may control light emitted from the plurality of light emitting elements to display characters, symbols, images, videos, or the like.

The display device includes a display substrate such as a PCB substrate on which an electric circuit is disposed, and the plurality of light emitting modules are disposed on the display substrate to be connected to the electric circuit.

In a conventional display device, since the plurality of light emitting elements are not firmly and reliably connected to the display substrate, display of characters, symbols, images, videos, or the like may not be smooth.

### DETAILED DESCRIPTION OF THE INVENTION

### TECHNICAL PROBLEMS

Embodiments of the present disclosure have been conceived in view of the above, and provide a light emitting module in which a plurality of light emitting elements can be firmly and reliably connected to a display substrate and a display device including the light emitting module.

### MEANS FOR SOLVING PROBLEMS

A light emitting module according to an aspect of the present disclosure may include: a module body including a base having an upper surface, a lower surface, and a plurality of peripheral surfaces connected to the upper surface and the lower surface; a plurality of electrodes disposed to be exposed to an outside on at least a part of the plurality of peripheral surfaces of the base; a plurality of light emitting elements disposed on the base to be connected to two or more of the plurality of electrodes; and a molding covering the plurality of light emitting elements.

Further, each of the plurality of electrodes may include an up-down extension portion disposed to extend in an up-down direction on at least one of the plurality of peripheral surfaces of the base; an upper extension portion extending from an upper end of the up-down extension portion on the upper surface of the base to be electrically connected to one or more of the plurality of light emitting elements; and a lower extension portion extending from a lower end of the up-down extension portion on the lower surface of the base.

Further, the plurality of peripheral surfaces may include a plurality of main surfaces having a flat shape; and a plurality of connecting curved surfaces disposed between neighboring main surfaces among the plurality of main surfaces and having a shape concavely curved toward a center of the base when viewed in the up-down direction, wherein the plurality of main surfaces and the plurality of connecting curved surfaces are alternately arranged along a circumferential direction, wherein at least a part of the up-down extension portions may be disposed on the connecting curved surface, wherein the molding may include a main molding covering the upper surface of the base and an electrode molding covering a part of the up-down extension portions, and wherein a lower part of the electrode molding may be formed so that a thickness thereof in a horizontal direction becomes thinner toward the lower side to provide a space portion.

Further, the lower surface of the base may include a first opposing side and a second opposing side extending in one direction and opposite to each other, wherein the plurality of lower extension portions may include first lower extension portions extending from the first opposing side and spaced apart from each other in the one direction, and second lower extension portions extending from the second opposing side and spaced apart from each other in the one direction, wherein a second center line may be disposed spaced apart from a first center line in the one direction, wherein a third center line may be disposed spaced apart from the first center line in another direction opposite to the one direction, wherein the first center line is defined as an imaginary line passing through a center of the first opposing side and a center of the second opposing side, wherein the second center line may be defined as an imaginary line passing through a center between the first lower extension portions, and wherein the third center line is defined as an imaginary line passing through a center between the second lower extension portions.

Further, the lower surface of the base may further include a first neighboring side connected to one end of the first opposing side and one end of the second opposing side, and a second neighboring side connected to the other end of the first opposing side and the other end of the second opposing side, and one of the first lower extension portions may extend to the first neighboring side, or one of the second lower extension portions may extend to the second neighboring side.

Further, the lower surface of the base may further include a first neighboring side connected to one end of the first opposing side and one end of the second opposing side, and a second neighboring side connected to the other end of the first opposing side and the other end of the second opposing side, and at least one of the first lower extension portion and the second lower extension portion may extend to pass through an imaginary fourth center line passing through a center of the first neighboring side and a center of the second neighboring side.

Further, each of the plurality of light emitting elements may include a P-type semiconductor and an N-type semiconductor, the plurality of light emitting elements may have the same arrangement of the P-type semiconductor and the N-type semiconductor, and the plurality of light emitting elements may have the same connection between each of the P-type semiconductor and the N-type semiconductor and the upper extension portion.

Further, each of the plurality of light emitting elements may include a P-type semiconductor and an N-type semiconductor, at least one of the plurality of light emitting elements may have a different arrangement of the P-type semiconductor and the N-type semiconductor, and the plurality of light emitting elements may have the same connection between each of the P-type semiconductor and the N-type semiconductor and the upper extension portion.

Further, each of the plurality of light emitting elements may include a P-type semiconductor and an N-type semiconductor, wherein the plurality of light emitting elements have the same arrangement of the P-type semiconductor and the N-type semiconductor, and at least one of the plurality of light emitting elements may have a different connection between each of the P-type semiconductor and the N-type semiconductor and the upper extension portion.

Further, each of the plurality of light emitting elements may include a P-type semiconductor and an N-type semiconductor, wherein at least one of the plurality of light emitting elements has a different arrangement of the P-type semiconductor and the N-type semiconductor, and at least one of the plurality of light emitting elements may have a different connection between each of the P-type semiconductor and the N-type semiconductor and the upper extension portion.

Further, the module body further includes a side wall portion extending upward from an edge of the upper surface of the base, and the side wall portion may provide a molding filling space in which the plurality of light emitting elements are disposed and the molding is filled.

Further, the side wall portion may be inclined so that a thickness thereof in a horizontal direction decreases as it goes upward.

Further, the base may be inclined so that a cross-sectional area thereof in a horizontal direction decreases as it goes downward.

Further, when an upper end of the side wall portion is projected directly downward onto an imaginary horizontal plane including a lower end of the base, the upper end of the side wall portion may surround the lower end of the base.

Further, on the lower surface of the base, an electrode arrangement groove in which the lower extension portion is disposed and which is depressed toward a center of the base in a horizontal direction may be formed, and the lower extension portion may extend to be inclined upward toward the center of the base in the horizontal direction.

Further, a direct upward distance between the lowermost end of the lower extension portion and the uppermost end of the lower extension portion may be greater than a direct upward distance between the lowermost end of the lower extension portion and the lowermost end of the base.

Further, a thickness t1 in the horizontal direction of the lowermost end of the up-down extension portion is smaller than a thickness t2 in the horizontal direction at a center of the up-down extension portion.

Further, the light emitting module may further include a control element connected to the plurality of light emitting elements through the plurality of electrodes to control the plurality of light emitting elements, and the control element may be disposed on the base and covered by the molding covering the plurality of light emitting elements.

Further, there may be provided a light emitting module including: a module body including a base having an upper surface, a lower surface, and a plurality of peripheral surfaces connected to the upper surface and the lower surface; a plurality of electrodes disposed to be exposed to an outside on at least a part of the plurality of peripheral surfaces of the base; a plurality of light emitting elements disposed on the base to be connected to two or more of the plurality of electrodes; and a molding covering the plurality of light emitting elements, wherein a partition groove is formed on an upper surface of the molding to partition an upper part of the molding into a plurality of light emitting regions, and wherein the plurality of light-emitting devices are disposed in each of the plurality of light-emitting regions.

Further, there may be provided a display device including: a display substrate on which an electric circuit is disposed; a plurality of light emitting modules disposed on the display substrate to be electrically connected to the electric circuit, wherein the light emitting module includes a module body including a base having an upper surface, a lower surface, and a plurality of peripheral surfaces connected to the upper surface and the lower surface; a plurality of electrodes disposed to be exposed to the outside on at least a part of the plurality of peripheral surfaces of the base; a plurality of light emitting elements disposed on the base to be connected to two or more of the plurality of electrodes; and a molding covering the plurality of light emitting elements.

### EFFECTS OF THE INVENTION

According to embodiments of the present disclosure, the plurality of light emitting modules can be firmly and reliably connected to the display substrate.

Further, according to embodiments of the present disclosure, characters, symbols, images, videos, or the like can be displayed smoothly.

### BRIEF DESCRIPTION OF THE DRAWINGS

FIG. 1 is a front view of a light emitting module according to a first embodiment of the present disclosure.
FIG. 2 is a side view of the light emitting module according to the first embodiment of the present disclosure.
FIG. 3 is a bottom view of the light emitting module according to the first embodiment of the present disclosure.
FIG. 4 is a cross-sectional view taken along line I-I' in FIG. 3.
FIG. 5 is a cross-sectional view taken along line II-II' in FIG. 3.
FIG. 6 is an enlarged bottom view of the light emitting modules of a display device according to the first embodiment of the present disclosure.
FIG. 7 is a bottom view of a light emitting module according to a second embodiment of the present disclosure.
FIG. 8 is a bottom view of a light emitting module according to a third embodiment of the present disclosure.
FIG. 9 is a bottom view of a light emitting module according to a fourth embodiment of the present disclosure.
FIG. 10 is a diagram illustrating arrangement of a P-type semiconductor and an N-type semiconductor of light emitting elements of a light emitting module according to a fifth embodiment of the present disclosure, and connection between each of the P-type semiconductor and the N-type semiconductor and an upper extension portion.
FIG. 11 is a diagram illustrating arrangement of a P-type semiconductor and an N-type semiconductor of light emitting elements of a light emitting module according to a sixth embodiment of the present disclosure, and connection between each of the P-type semiconductor and the N-type semiconductor and an upper extension portion.
FIG. 12 is a diagram illustrating arrangement of a P-type semiconductor and an N-type semiconductor of light emitting elements of a light emitting module according to a seventh embodiment of the present disclosure, and connection between each of the P-type semiconductor and the N-type semiconductor and an upper extension portion.
FIG. 13 is a front view of a light emitting module according to an eighth embodiment of the present disclosure.
FIG. 14 is a side view of the light emitting module according to the eighth embodiment of the present disclosure.
FIG. 15 is a bottom view of the light emitting module according to the eighth embodiment of the present disclosure.
FIG. 16 is a cross-sectional view taken along line III-III' in FIG. 15.
FIG. 17 is a cross-sectional view along line IV-IV' in FIG. 15.
FIG. 18 is a plan view of molding of a light emitting module according to a ninth embodiment of the present disclosure.
FIG. 19 is a cross-sectional view along line V-V' in FIG. 18.
FIG. 20 is a plan view of a molding of a light emitting module according to a tenth embodiment of the present disclosure.
FIG. 21 is a front view of the molding of the light emitting module according to the tenth embodiment of the present disclosure.
FIG. 22 is a side view of the molding of the light emitting module according to the tenth embodiment of the present disclosure.
FIG. 23 is a bottom view of the light emitting module according to the tenth embodiment of the present disclosure.
FIG. 24 is a view showing a partition groove of a molding of a light emitting module according to an eleventh embodiment of the present disclosure.
FIG. 25 is a view showing partition grooves of a molding of a light emitting module according to a twelfth embodiment of the present disclosure.

### MODE FOR IMPLEMENTING THE INVENTION

Hereinafter, specific embodiments for implementing a spirit of the present disclosure will be described in detail with reference to the drawings.

In describing the present disclosure, detailed descriptions of known configurations or functions may be omitted to clarify the present disclosure.

When an element is referred to as being 'connected' to, 'supported' by, or 'supplied' to another element, it should be understood that the element may be directly connected to, supported by, or supplied to another element, but that other elements may exist in the middle.

The terms used in the present disclosure are only used for describing specific embodiments, and are not intended to limit the present disclosure. Singular expressions include plural expressions unless the context clearly indicates otherwise.

Further, in the present disclosure, it is to be noted that expressions, such as the upper surface, the lower surface, the circumferential surface, the front surface, the left side surface, the right side surface, the rear surface, the first horizontal direction, the second horizontal direction and the up and down direction, are described based on the illustration of drawings, but may be modified if directions of corresponding objects are changed. For the same reasons, some components are exaggerated, omitted, or schematically illustrated in the accompanying drawings, and the size of each component does not fully reflect the actual size.

Terms including ordinal numbers, such as first and second, may be used for describing various elements, but the corresponding elements are not limited by these terms. These terms are only used for the purpose of distinguishing one element from another element.

In the present specification, it is to be understood that the terms such as "including" are intended to indicate the existence of the certain features, areas, integers, steps, actions, elements, combinations, and/or groups thereof disclosed in the specification, and are not intended to preclude the possibility that one or more other certain features, areas, integers, steps, actions, elements, combinations, and/or groups thereof may exist or may be added.

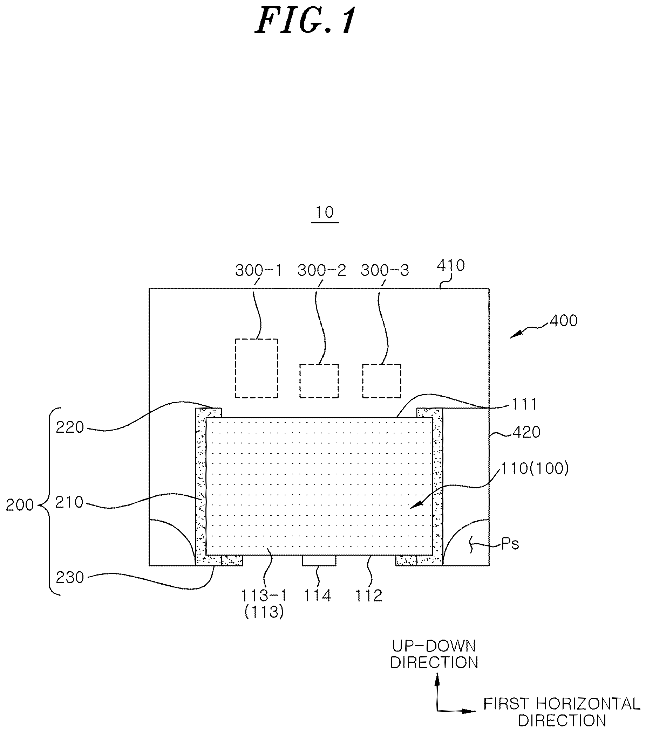

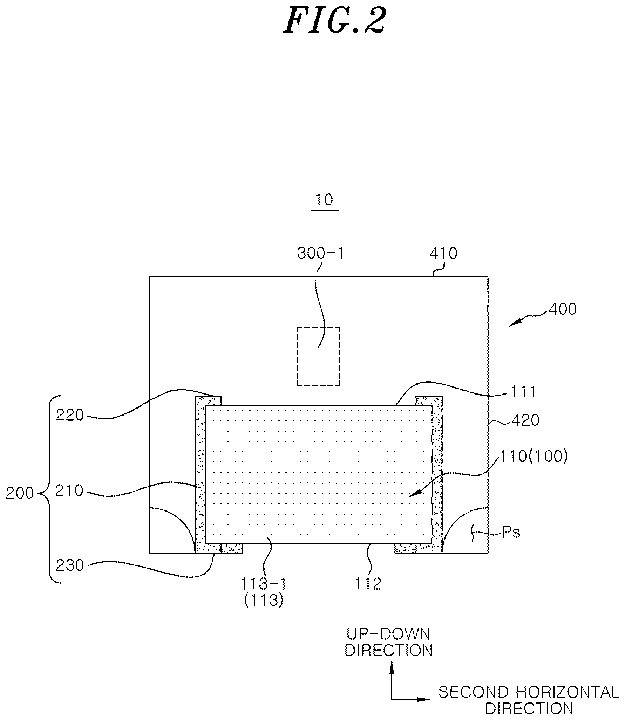

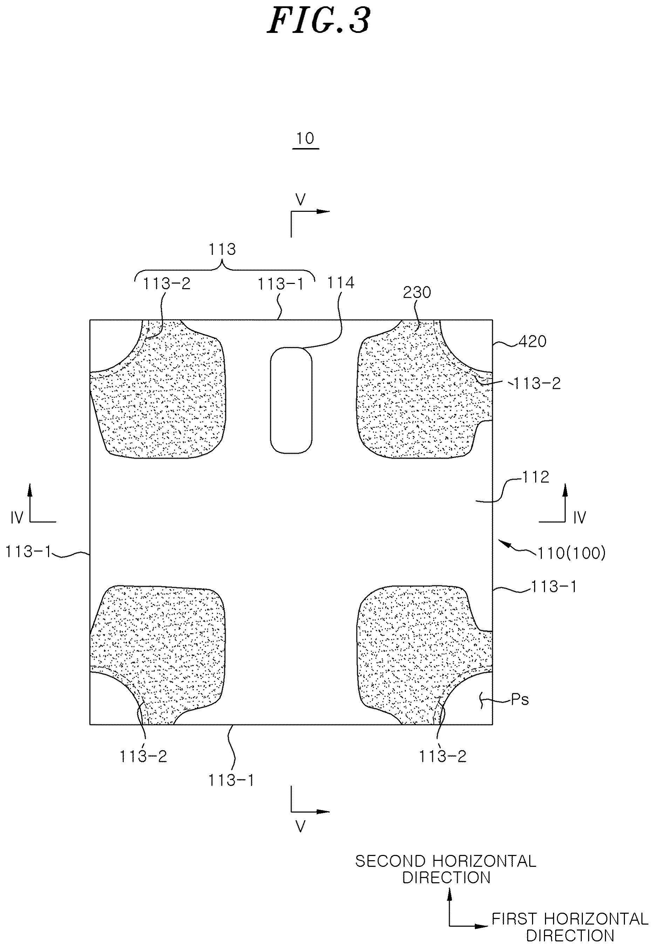

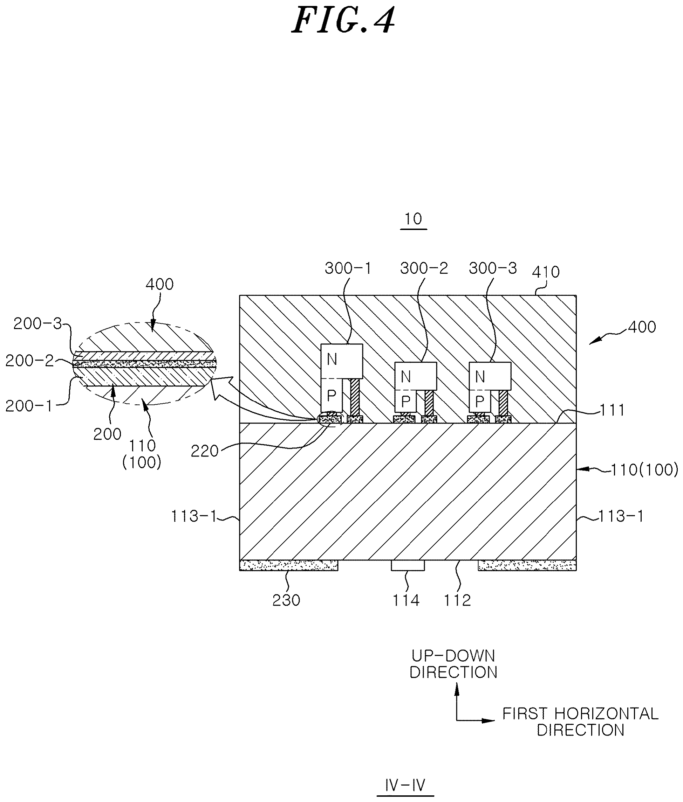

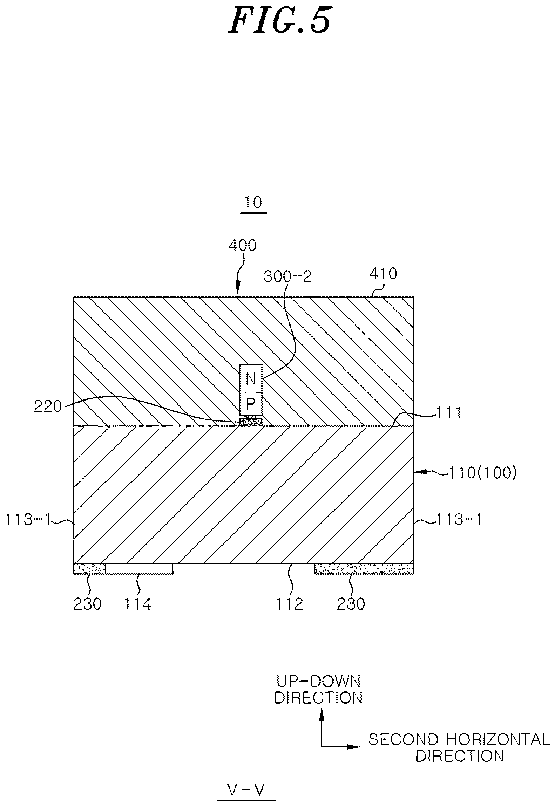

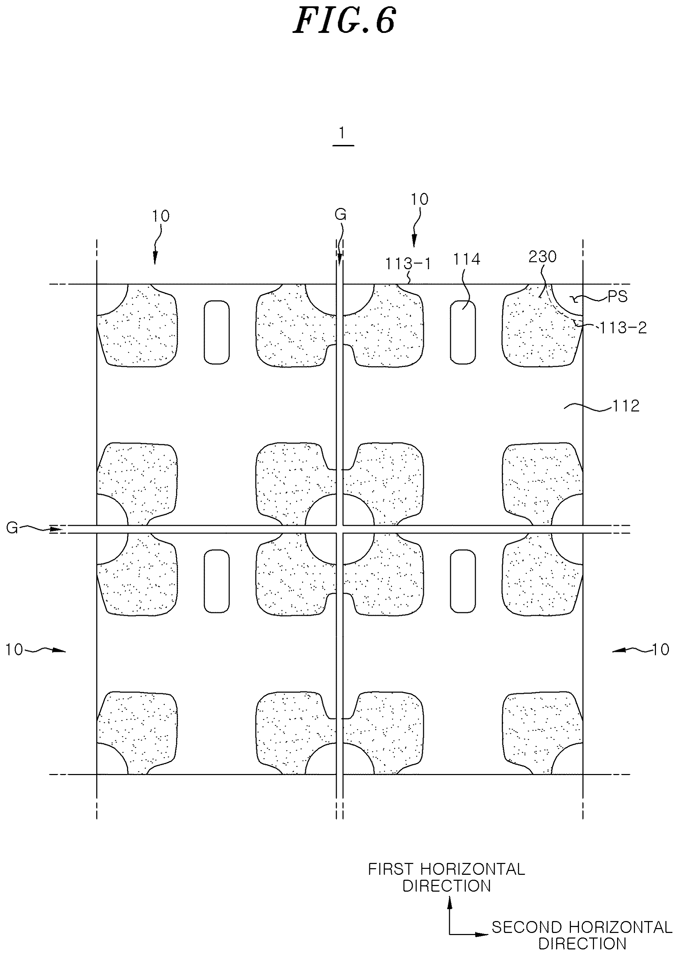

Hereinafter, specific configurations of a light emitting module according to a first embodiment of the present disclosure and a display device including the light emitting module will be described with reference to FIGS. 1 to 6.

A light emitting module 10 according to the first embodiment of the present disclosure can emit light by receiving electricity from the outside. The light emitting module 10 may include a module body 100, a plurality of electrodes 200, a plurality of light emitting elements 300-1, 300-2, and 300-3, and a molding 400.

The module body 100 may support the plurality of electrodes 200, the plurality of light emitting elements 300-1, 300-2, and 300-3, and the molding 400. The module body 100 may include a base 110.

The plurality of electrodes 200, the plurality of light emitting elements 300-1, 300-2, and 300-3, and the molding 400 may be disposed and supported on the base 110. The base 110 may include an upper surface 111, a lower surface 112, and a plurality of peripheral surfaces 113.

The upper surface 111 and the lower surface 112 of the base 110 are each a flat plane in a horizontal direction and may be spaced apart from each other in an up-down direction perpendicular to the horizontal direction. Each of the plurality of peripheral surfaces 113 of the base 110 may be connected to the upper surface 111 and the lower surface 112. The plurality of peripheral surfaces 113 may include a plurality of main surfaces 113-1 and a plurality of connecting curved surfaces 113-2. The plurality of main surfaces 113-1 may have a flat shape. The plurality of main surfaces 113-1 may be flat planes in the up-down direction. For example, the number of the main surfaces 113-1 may be four. In addition, the four main surfaces 113-1 may be front, rear, left, and right surfaces, respectively. The plurality of connecting curved surfaces 113-2 may be disposed between neighboring main surfaces 113-1 among the plurality of main surfaces 113-1. In addition, the plurality of connecting curved surfaces 113-2 may have a shape curved concavely toward a center of the base 110 when viewed in the up-down direction. For example, the number of the connecting curved surfaces 113-2 may be four.

Meanwhile, the plurality of main surfaces 113-1 and the plurality of connecting curved surfaces 113-2 may be alternately arranged along a circumferential direction. For example, four main surfaces 113-1 may be a front surface, a left surface, a right surface, and a rear surface. In addition, there are four connecting curved surfaces 113-2, and the four connecting curved surfaces 113-2 may be respectively disposed between the front and left surfaces, between the front and right surfaces, between the rear and left surfaces, and between the rear and right surfaces, which are the main surfaces 113-1.

The base 110 may further include a support part 114. The support part 114 may be spaced apart from a center of the lower surface 112 of the base 110. The arrangement direction of the light emitting module 10 may be known as the support part 114 is disposed spaced apart from the center of the lower surface 112 of the base 110. In addition, a plurality of light emitting modules 10 may be arranged in the same direction. For example, the support part 114 may be disposed between lower extension portions 230, to be described later, which are included in the electrode 200 and are spaced apart from the center of the lower surface 112 and spaced apart from each other in one direction.

The plurality of electrodes 200 may connect the plurality of light emitting elements 300-1, 300-2, and 300-3 to a power source so that light is emitted from the plurality of light emitting elements 300-1, 300-2, and 300-3. One or more of the plurality of electrodes 200 may be connected to all of the plurality of light emitting elements 300-1, 300-2, and 300-3. In other words, one or more of the plurality of electrodes 200 may be a common electrode. Also, among the plurality of electrodes 200, each of the electrodes 200 that are not the common electrode may be connected to each of the plurality of light emitting elements 300-1, 300-2, and 300-3. The number of the plurality of electrodes 200 may be greater than the number of the plurality of light emitting elements 300-1, 300-2, and 300-3 by one or more. For example, the number of the plurality of electrodes 200 may be four, and the number of the plurality of light emitting elements 300-1, 300-2, and 300-3 may be three.

The plurality of electrodes 200 may be disposed to be exposed to the outside on at least a portion of the plurality of peripheral surfaces 113 of the base 110. The plurality of electrodes 200 may be connected to an electric circuit disposed on a display substrate, to be described later, included in the display device 1. The plurality of electrodes 200 may be connected to the electric circuit of the display substrate through a conductive material or adhesive material. When the plurality of electrodes 200 are disposed to be exposed to the outside on at least a portion of the plurality of peripheral surfaces 113 of the base 110, the contact area of the conductive material or the adhesive material with the plurality of electrodes 200 may increase. Therefore, the connection between the plurality of electrodes 200 and the display substrate can be firmly and reliably performed. The electrode 200 may include an up-down extension portion 210, an upper extension portion 220, and a lower extension portion 230.

The up-down extension portion 210 may be disposed to extend in the up-down direction on one or more of the plurality of peripheral surfaces 113 of the base 110. At least a portion of the up-down extension portion 210 may be disposed on the connecting curved surface 113-2 of the peripheral surfaces 113 of the base 110. The portion of the up-down extension portion 210 disposed on the connecting curved surface 113-2 of the peripheral surfaces 113 of the base 110 may have the same concave shape as the connecting curved surface 113-2. The up-down extension portion 210 may be disposed on a part of each of the neighboring main surfaces 113-1, among the peripheral surfaces 113 of the base 110, and on the connecting curved surfaces 113-2 disposed between the neighboring main surfaces 113-1.

The number of the electrodes 200 and the number of the connecting curved surfaces 113-2 may be the same. For example, the number of the plurality of electrodes 200 may be four, and the main surface 113-1 may also have four front, left, right, and rear surfaces. In addition, the number of the connecting curved surfaces 113-2 may also be four, and the four connecting curved surfaces 113-2 may be respectively disposed between the front and left surfaces, between the front and right surfaces, between the rear and left surfaces, and between the rear and right surfaces, which are the main surfaces 113-1. In addition, the up-down extension portion 210 of one of the four electrodes 200 may be disposed to extend in the up-down direction on a portion of each of the front and left surfaces of the main surfaces 113-1 and on the connecting curved surface 113-2 disposed between the front and left surfaces. In addition, the up-down extension portion 210 of another one of the four electrodes 200 may be disposed to extend in the up-down direction on a portion of each of the front and right surfaces of the main surfaces 113-1 and on the connecting curved surface 113-2 disposed between the front and right surfaces. Further, the up-down extension portion 210 of still another one of the four electrodes 200 may be disposed to extend in the up-down direction on a portion of each of the rear and left surfaces of the main surfaces 113-1 and the connecting curved surface 113-2 disposed between the rear and left surfaces. In addition, the up-down extension portion 210 of still another one of the four electrodes 200 may be disposed to extend in the up-down direction on a portion of each of the rear and right surfaces of the main surfaces 110-1 and on the connecting curved surface 113-2 disposed between the rear and right surfaces.

At least a portion of the up-down extension portions 210 may be exposed to the outside. For example, a portion of the up-down extension portions 210 extending along the main surfaces 113-1 of the base 110 may be exposed to the outside.

The upper extension portion 220 may extend from an upper end of the up-down extension portions 210 on the upper surface 111 of the base 110. Further, the upper extension portion 220 may be electrically connected to one or more of the plurality of light emitting elements 300-1, 300-2, and 300-3. The number of the electrodes 200 may be greater than the number of the light emitting elements 300-1, 300-2, and 300-3. For example, the number of the electrodes 200 may be four, and the number of the light emitting elements 300-1, 300-2, and 300-3 may be three. In addition, the upper surface extension 220 of one of the four electrodes 200 may be electrically connected to all of the three light emitting elements 300-1, 300-2, and 300-3. Further, the upper surface extensions 220 of the other three of the four electrodes 200 may be electrically connected to the three light emitting elements 300-1, 300-2, and 300-3, respectively.

The lower extension portion 230 may extend from a lower end of the up-down extension portion 210 on the lower surface 112 of the base 110. At least a portion of the lower extension portion 230 may be exposed to the outside. The lower extension portion 230 may be connected to an electric circuit disposed on a display substrate, to be described later, included in the display device 1 to be connected to a power source. The lower extension portion 230 may be connected to the electric circuit of the display substrate through a conductive material or adhesive material. For example, the lower extension portion 230 may be connected to the electric circuit of the display substrate by soldering.

The lower extension portion 230 may be arranged to face each other in one or more of a first horizontal direction, a second horizontal direction, and a diagonal direction of the lower surface of the base 110 on the lower surface of the base 110. In this case, the first horizontal direction may be a transverse direction and the second horizontal direction may be a lengthwise direction perpendicular to the transverse direction. Further, the transverse direction may be a direction in which the plurality of light emitting elements 300-1, 300-2, and 300-3 are arranged.

Meanwhile, additionally, the electrode 200 may include a first electrode layer 200-1, a second electrode layer 200-2, and a third electrode layer 200-3. The first electrode layer 200-1 may be disposed on the base 110 of the module body 100. The second electrode layer 200-2 may be disposed on the first electrode layer 200-1. The third electrode layer 200-3 may be disposed on the second electrode layer 200-2. A thermal expansion coefficient of the first electrode layer 200-1 may be greater than a thermal expansion coefficient of the second electrode layer 200-2 and a thermal expansion coefficient of the third electrode layer 200-3. Further, the thermal expansion coefficient of the second electrode layer 200-2 may be smaller than that of the third electrode layer 200-3. In other words, the first electrode layer 200-1 has the largest thermal expansion coefficient, the second electrode layer 200-2 has the smallest thermal expansion coefficient, and the thermal expansion coefficient of the third electrode layer 200-3 may be between the thermal expansion coefficient of the first electrode layer 200-1 and the thermal expansion coefficient of the second electrode layer 200-2. Since the second electrode layer 200-2 having the smallest coefficient of thermal expansion is disposed between the first electrode layer 200-1 and the third electrode layer 200-3, the electrode 200 may not be vulnerable to thermal stress. For example, the first electrode layer 200-1 may contain copper. Further, the second electrode layer 200-2 may contain nickel. In addition, the third electrode layer 200-3 may contain gold. Meanwhile, the third electrode layer 200-3 may not exist.

The plurality of light emitting elements 300-1, 300-2, and 300-3 may emit light. The plurality of light emitting elements 300-1, 300-2, and 300-3 may emit light having the same peak wavelength. In addition, one or more of the plurality of light emitting elements 300-1, 300-2, and 300-3 may emit light having a different peak wavelength. Further, the plurality of light emitting elements 300-1, 300-2, and 300-3 may emit lights having different peak wavelengths, respectively. In other words, the plurality of light emitting elements 300-1, 300-2, and 300-3 may emit light of the same color. In addition, one or more of the plurality of light emitting elements 300-1, 300-2, and 300-3 may emit light of a different color. Further, the plurality of light emitting elements 300-1, 300-2, and 300-3 may emit lights of different colors, respectively.

For example, the plurality of light emitting elements 300-1, 300-2, and 300-3 may include a first light emitting element 300-1, a second light emitting element 300-2, and a third light emitting element 300-3. The first light emitting element 300-1, the second light emitting element 300-2, and the third light emitting element 300-3 may emit light of the same color. In addition, one or more of the first light emitting element 300-1, the second light emitting element 300-2, and the third light emitting element 300-3 may emit light of a different color. Further, the first light emitting element 300-1, the second light emitting element 300-2, and the third light emitting element 300-3 may emit lights of different colors, respectively. The first light emitting element 300-1 may emit red light having the longest peak wavelength, and the second light emitting element 300-2 may emit green light having a shorter peak wavelength than that of the first light emitting element 300-1, and the third light emitting element 300-3 may emit blue light having the shortest peak wavelength. The upper surface of the first light emitting element 300-1 emitting light of the longest peak wavelength may be higher than those of the second light emitting element 300-2 and the third light emitting element 300-3. The deviation in height between the first light emitting element 300-1 emitting light of the longest peak wavelength and the other light emitting elements 300-2 and 300-3 may be within 40%.

The plurality of light emitting elements 300-1, 300-2, and 300-3 may be disposed on the base 110 to be connected to two or more of the plurality of electrodes 200. The plurality of light emitting elements 300-1, 300-2, and 300-3 may be connected to a common electrode among the plurality of electrodes 200. Further, the plurality of light emitting elements 300-1, 300-2, and 300-3 may be connected to the respective electrodes other than the common electrode among the plurality of electrodes 200. The plurality of light emitting elements 300-1, 300-2, and 300-3 may be connected to two or more of the upper extension portions 220 of the plurality of electrodes 200.

Each of the plurality of light emitting elements 300-1, 300-2, and 300-2 may include a P-type semiconductor P and an N-type semiconductor N. Further, in the plurality of light emitting elements 300-1, 300-2, and 300-3, the arrangement of the P-type semiconductor P and the N-type semiconductor N may be the same. For example, in the plurality of light emitting elements 300-1, 300-2, and 300-3, the N-type semiconductor N may be disposed on the P-type semiconductor P. In addition, in the plurality of light emitting elements 300-1, 300-2, and 300-3, the connection between each of the P-type semiconductor P and the N-type semiconductor N and the upper extension portion 220 may be the same. For example, the P-type semiconductor P and the N-type semiconductor N of each of the plurality of light emitting elements 300-1, 300-2, and 300-3 may be directly connected to the upper extension portion 220 through a conductive material or adhesive material. In addition, in the plurality of light emitting elements 300-1, 300-2, and 300-3, the connection directions between each of the P-type semiconductor P and the N-type semiconductor N and the upper extension portion 220 may be the same. For example, the conductive materials electrically connected to the P-type semiconductor P and the N-type semiconductor N of each of the plurality of light emitting elements 300-1, 300-2, and 300-3 may be disposed to face the same direction and may be electrically connected to the upper extension portion 220.

Although not shown, in another embodiment, each of the plurality of light emitting elements 300-1, 300-2, and 300-2 may include a P-type semiconductor P and an N-type semiconductor N, and in at least one of the plurality of light emitting elements 300-1, 300-2, and 300-3, the arrangement of the P-type semiconductor P and the N-type semiconductor N may be different from the other. For example, the order in which the P-type semiconductor P and the N-type semiconductor N are arranged in the first light-emitting device 300-1 may be opposite to the order in which the P-type semiconductor P and the N-type semiconductor N are arranged in the second light-emitting device 300-2 and the third light-emitting device 300-3.

The plurality of light emitting elements 300-1, 300-2, and 300-3 may be flip chips. When the plurality of light emitting elements 300-1, 300-2, and 300-3 are flip chips, the P-type semiconductor P and the N-type semiconductor N of each of the plurality of light emitting elements 300-1, 300-2, and 300-3 may be directly connected to the upper extension portion 220 through a conductive material such as silver paste. Further, the plurality of light emitting elements 300-1, 300-2, and 300-3 may be lateral chips. When the plurality of light emitting elements 300-1, 300-2, and 300-3 are lateral chips, the P-type semiconductor P and the N-type semiconductor N of each of the plurality of light emitting elements 300-1, 300-2, and 300-3 includes may be connected to the upper extension portion 220 through a wire W, which will be described later. When the plurality of light emitting elements 300-1, 300-2, and 300-3 are lateral chips, the plurality of light emitting elements 300-1, 300-2, and 300-3 may be connected to the upper surface 111 of the base 110 through silicon.

The molding 400 may transmit light emitted from the plurality of light emitting elements 300-1, 300-2, and 300-3 while protecting the plurality of light emitting elements 300-1, 300-2, and 300-3. The molding 400 may cover the plurality of light emitting elements 300-1, 300-2, and 300-3. The molding 400 may include a main molding 410 and an electrode molding 420.

The main molding 410 may cover the upper surface 111 of the base 110. In addition, the electrode molding 420 may cover a portion of the up-down extension portions 210 of the electrode 200. A lower portion of the electrode molding 420 may be formed to have a thinner horizontal thickness toward the lower side to provide a space portion PS. For example, the space portion PS may be formed at each lower corner of the light emitting module 10. The space portion PS may have a concave shape. For example, the space portion PS may have a concave shape similar to a 1/8 spherical shape. The space portion PS may be empty. In addition, the space portion PS may be at least partially filled with a conductive material or adhesive material. In addition, an electrode material may be coated on an inner surface of the space portion PS.

A first embodiment of the display device 1 according to the present disclosure may display characters, symbols, images, videos, or the like. The display device 1 may include a display substrate and a plurality of light emitting modules 10.
An electric circuit may be disposed on the display substrate. For example, the display substrate may be a PCB substrate on which an electric circuit is printed.

The plurality of light emitting modules 10 may be disposed on the display substrate to be connected to the electric circuit. The plurality of light emitting modules 10 may be connected to the electric circuit of the display substrate through a conductive material or adhesive material. The lower extension portion 230 of the electrode 200 of the light emitting module 10 may be connected to the electric circuit of the display substrate through a conductive material or adhesive material. For example, the lower extension portions 230 of the electrode 200 of the plurality of light emitting modules 10 may be connected to the electric circuit of the display substrate by soldering.

When the plurality of light emitting modules 10 are disposed on the display substrate to be connected to the electric circuit of the display substrate, an imaginary line connecting the lower boundary of the space portions PS of the adjacent light emitting modules 10 may form a circle or an ellipse. For example, an imaginary line connecting the lower boundary of the space portions PS of four adjacent light emitting modules 10 may form a circle or an ellipse. The lower extension portion 230 of the electrode 200 of the light emitting module 10 may be connected to the electric circuit of the display substrate through a conductive material or adhesive material. In addition, since the conductive material or the adhesive material may flow into the space portions PS of the adjacent light emitting modules 10, the contact area of the conductive material or the adhesive material may be increased. Accordingly, the connection of the light emitting module 10 to the display substrate can be performed firmly and reliably. In addition, since the space portion PS of the light emitting module 10 forms a concave curved surface, it may not be vulnerable to thermal stress or the like.

The plurality of light emitting modules 10 may be arranged spaced apart from each other by a separation space G, and the space portions PS of the adjacent light emitting module 10 may be also spaced apart by the separation space G. The separation space G may be formed in a column shape or a mesh shape.

Meanwhile, in addition to such configurations, according to second to fourth embodiments of the present disclosure, the lower extension portion 230 of the electrode 200 may extend on the lower surface 112 of the base 110 while having a shape or arrangement different from that of the above-described first embodiment.

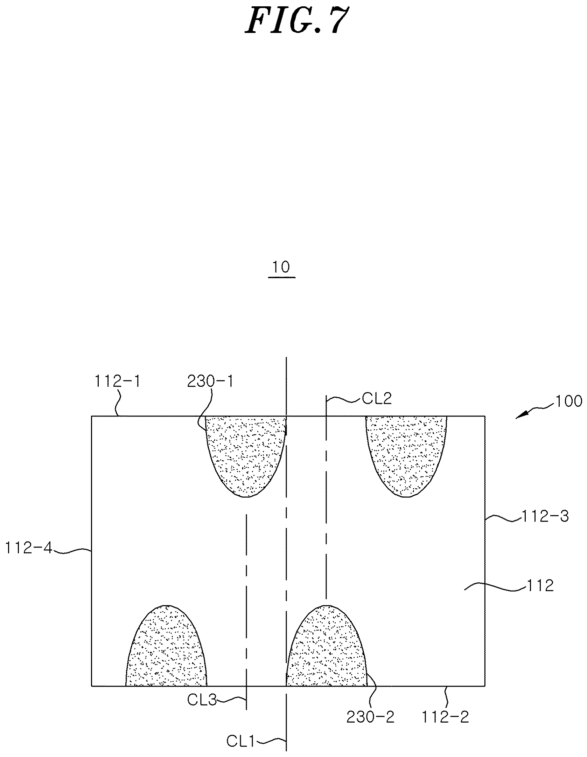

Hereinafter, the second embodiment will be described below with reference to FIG. 7. In describing the second embodiment of the present disclosure, the differences from the above-described embodiment are mainly described, and the same description and reference numerals refer to the above-described embodiment.

Referring to FIG. 7, the lower surface 112 of the base 110 extends in one direction and may include a first opposing side 112-1 and a second opposing side 112-2 which are opposite to each other.

In addition, the plurality of lower extension portions 230 may include first lower extension portions 230-1 and second lower extension portions 230-2. The first lower extension portions 230-1 may extend from the first opposing side 112-1 and may be disposed spaced apart from each other in one direction. In addition, the second lower extension portions 230-2 may extend from the second opposing side 112-2 and may be disposed spaced apart from each other in one direction.

Meanwhile, a second center line CL2 may be disposed apart from a first center line CL1 in one direction, and a third center line CL3 may be disposed apart from the first center line CL1 in another direction opposite to one direction.

Further, the first center line CL1 may be defined as an imaginary line passing through the center of the first opposing side 112-1 and the center of the second opposing side 112-2. In addition, the second center line CL2 may be defined as an imaginary line passing through the center between the first lower extension portions 230-1. Further, the third center line CL3 may be defined as an imaginary line passing through the center between the second lower extension portions 230-2.

In other words, the first extension portions 230-1 and the second extension portions 230-2 may be arranged to be staggered from each other, and the first extension portions 230-1 may be biased in one direction while the second extension portions 230-1 may be biased in the other direction. With such configurations, even when the size of the light emitting module 10 is reduced due to a decrease in the size of the light emitting elements 300-1, 300-2, and 300-3, etc., the lower extension portion 230 can be easily disposed on the lower surface 112 of the base 110.

Meanwhile, in addition to such configurations, according to the third embodiment of the present disclosure, one of the first lower extension portions 230-1 may extend to a first neighboring side 112-3 neighboring the first opposing side 112-1 in one direction, or one of the second lower extension portions 230-2 may extend to a second neighboring side 112-4 neighboring the second opposing side 112-2 in the other direction.

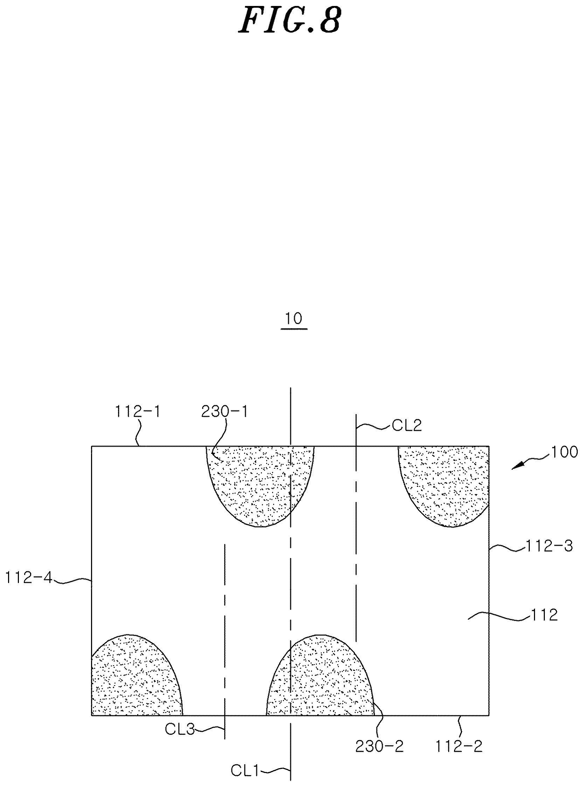

Hereinafter, the third embodiment will be described with reference to FIG. 8. In describing the third embodiment of the present disclosure, the differences from the above-described embodiments are mainly described, and the same description and reference numerals refer to the above-described embodiments.

Referring to FIG. 8, the lower surface 112 of the base 110 may further include a first neighboring side 112-3 and a second neighboring side 112-4. The first neighboring side 112-3 may be connected to one end of the first opposing side 112-1 and one end of the second opposing side 112-2. Further, the second neighboring side 112-4 may be connected to the other end of the first opposing side 112-1 and the other end of the second opposing side 112-2.

In addition, one of the first lower extension portions 230-1 may extend to the first neighboring side 112-3, or one of the second lower extension portions 230-2 may extend to the second neighboring side 112-4.

With such configurations, even when the size of the light emitting module 10 is reduced due to a decrease in the size of the light emitting elements 300-1, 300-2, and 300-3, etc., the lower extension portion 230 can be easily disposed on the lower surface 112 of the base 110.

Meanwhile, in addition to such configurations, according to the fourth embodiment of the present disclosure, at least one of the first lower extension portion 230-1 and the second lower extension portion 230-2 may extend to pass through an imaginary fourth center line CL4 passing through the center of the first neighboring side 112-3 and the center of the second neighboring side 112-4.

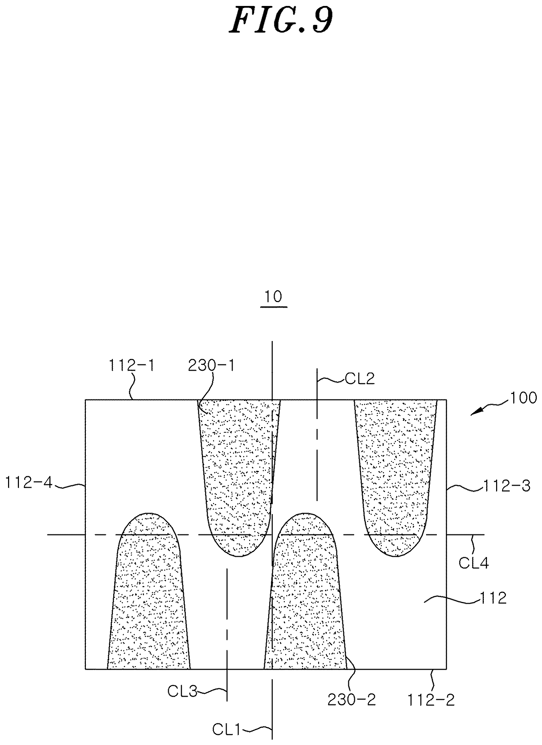

Hereinafter, the fourth embodiment will be described with reference to FIG. 9. In describing the fourth embodiment of the present disclosure, the differences from the above-described embodiments are mainly explained, and the same description and reference numerals refer to the above-described embodiments.

Referring to FIG. 9, at least one of the first lower extension portion 230-1 and the second lower extension portion 230-2 may extend to pass through the imaginary fourth center line CL4 passing through the center of the first neighboring side 112-3 and the center of the second neighboring side 112 -4.

With such configurations, even when the size of the light emitting module 10 is reduced due to a decrease in the size of the light emitting elements 300-1, 300-2, and 300-3, etc., the lower extension portion 230 can be easily disposed on the lower surface 112 of the base 110.

Meanwhile, in addition to such configurations, according to fifth to seventh embodiments of the present disclosure, the arrangement of the P-type semiconductor P and the N-type semiconductor N included in each of the plurality of light-emitting elements 300-1, 300-2, and 300-3, or the connection between each of the P-type semiconductor P and the N-type semiconductor N and the upper extension portion 220 may be different from that of the first embodiment described above.

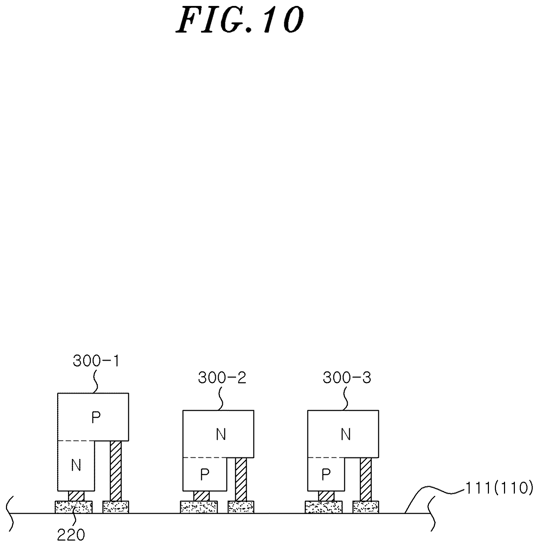

Hereinafter, the fifth embodiment will be described with reference to FIG. 10. In describing the fifth embodiment of the present disclosure, the differences from the above-described embodiments are mainly explained, and the same description and reference numerals refer to the above-described embodiments.

Referring to FIG. 10, at least one of the plurality of light emitting elements 300-1, 300-2, and 300-3 may have a different arrangement of the P-type semiconductor P and the N-type semiconductor N. For example, in at least one light emitting element 300-1 among the plurality of light emitting elements 300-1, 300-2, and 300-3, the P-type semiconductor P may be disposed on the N-type semiconductor N. Further, in the other light emitting elements 300-2 and 300-3, the N-type semiconductor N may be disposed on the P-type semiconductor P. The light emitting element 300-1 having a different arrangement of the P-type semiconductor P and N-type semiconductor N may be the light emitting element 300-1 that emits red light. For example, the light-emitting device 300-1 having the different arrangement of the P-type semiconductor P and the N-type semiconductor N may be the first light-emitting device 300-1 that emits red light.

In addition, in the plurality of light emitting elements 300-1, 300-2, and 300-3, the connection between each of the P-type semiconductor P and the N-type semiconductor N and the upper extension portion 220 may be the same. For example, each of the P-type semiconductor P and the N-type semiconductor N in the plurality of light emitting elements 300-1, 300-2, and 300-3 may be directly connected on the upper extension portion 220 through a conductive material or adhesive material. For example, each of the P-type semiconductor P and the N-type semiconductor N in the plurality of light emitting elements 300-1, 300-2, and 300-3 may be directly connected to the upper extension portion 220 through silver paste. The plurality of light emitting elements 300-1, 300-2, and 300-3 may be flip chips.

Meanwhile, in addition to such configurations, according to the sixth embodiment of the present disclosure, the plurality of light emitting elements 300-1, 300-2, and 300-3 may have the same arrangement of the P-type semiconductor P and the N-type semiconductor N, and at least one of the plurality of light emitting elements 300-1, 300-2, 300-3 may have a different connection between each of the P-type semiconductor P and the N-type semiconductor N and the upper extension portion 220.

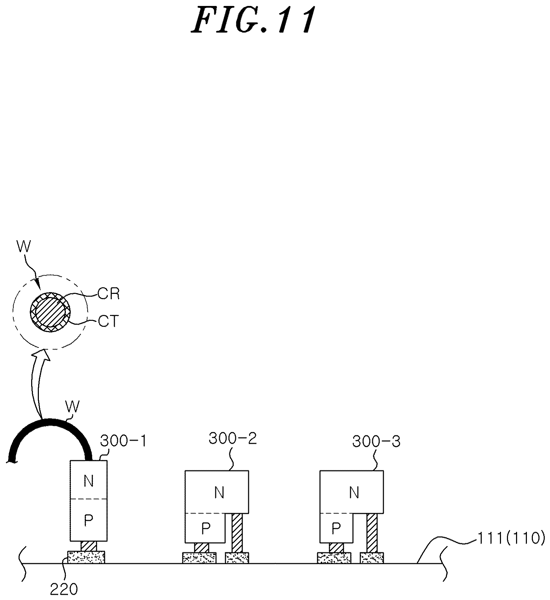

Hereinafter, the sixth embodiment will be described with reference to Fig. 11. In describing the sixth embodiment of the present disclosure, the differences from the above-described embodiments are mainly described, and the same description and reference numerals refer to the above-described embodiments.

Referring to FIG. 11, in the plurality of light emitting elements 300-1, 300-2, and 300-3, the arrangement of the P-type semiconductor P and the N-type semiconductor N may be the same. For example, in the plurality of light emitting elements 300-1, 300-2, and 300-3, the N-type semiconductor N may be disposed on the P-type semiconductor P.

In addition, at least one of the plurality of light emitting elements 300-1, 300-2, and 300-3 may have a different connection between each of the P-type semiconductor P and the N-type semiconductor N and the upper extension portion 220. For example, the P-type semiconductor P of at least one light emitting element 300-1 among the plurality of light emitting elements 300-1, 300-2, and 300-3 may be directly connected to the upper extension portion 220 through a conductive material or adhesive material. Further, the N-type semiconductor N of at least one light emitting element 300-1 among the plurality of light emitting elements 300-1, 300-2, and 300-3 may be connected to the upper extension portion 220 through a wire W. In addition, in the other light emitting elements 300-2 and 300-3, each of the P-type semiconductor P and the N-type semiconductor N may be directly connected to the upper extension portion 220 through a conductive material or adhesive material. The light emitting element 300-1 having the different connection between each of the P-type semiconductor P and the N-type semiconductor N and the upper surface extension 220 may be the light emitting element 300-1 that emits red light having the longest peak wavelength. For example, the light emitting element 300-1 having the different connection between each of the P-type semiconductor P and the N-type semiconductor N and the upper surface extension 220 may be the first light-emitting device 300-1 that emits red light.

Among the plurality of light emitting elements 300-1, 300-2, and 300-3, the light emitting element 300-1 having the different connection between each of the P-type semiconductor P and the N-type semiconductor N and the upper extension portion 220 may be a vertical chip. In addition, the light emitting elements 300-2 and 300-3 that are not the vertical chip may be flip chips. For example, the first light emitting element 300-1 that emits red light may be a vertical chip. Further, the second light emitting element 300-2 and the third light emitting element 300-3 may be flip chips.

The aforementioned wire W may include a core CR and a coating layer CT coated on the outer periphery of the core CR. The reflectance of the coating layer CT may be higher than that of the core CR. Accordingly, even when the wire W is disposed within the molding 400, the wire W may not prevent light emitted from the plurality of light emitting elements 300-1, 300-2, and 300-3 from passing through the molding 400 to be emitted to the outside. For example, the core CR may contain copper. Further, the coating layer CT may contain palladium.

Meanwhile, in addition to such configurations, according to the seventh embodiment of the present disclosure, at least one of the plurality of light emitting elements 300-1, 300-2, and 300-3 may have a different arrangement of the P-type semiconductor P and the N-type semiconductor N and a different connection between each of the P-type semiconductor P and the N-type semiconductor N and the upper extension portion 220.

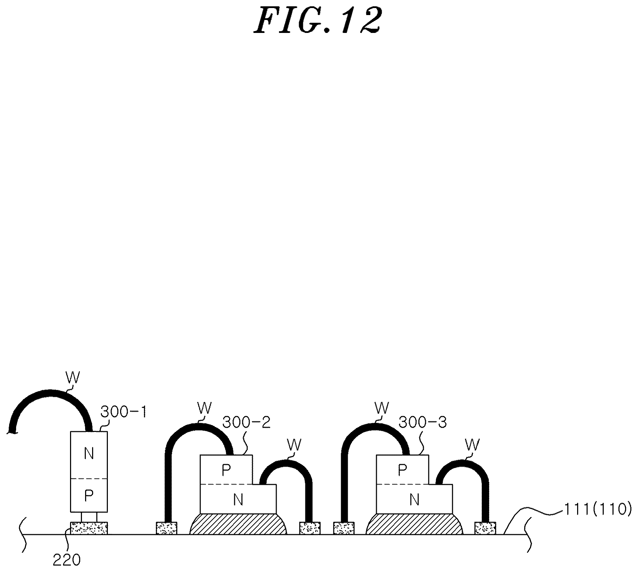

Hereinafter, the seventh embodiment will be described with reference to FIG. 12. In describing the seventh embodiment of the present disclosure, the differences from the above-described embodiments are mainly explained, and the same description and reference numerals refer to the above-described embodiments.

Referring to FIG. 12, at least one of the plurality of light emitting elements 300-1, 300-2, and 300-3 may have a different arrangement of the P-type semiconductor P and the N-type semiconductor N. For example, in at least one light emitting element 300-1 among the plurality of light emitting elements 300-1, 300-2, and 300-3, the N-type semiconductor N may be disposed on the P-type semiconductor P. Further, in the other light emitting elements 300-2 and 300-3, the P-type semiconductor P may be disposed on the N-type semiconductor N. The light emitting element 300-1 having a different arrangement of the P-type semiconductor P and N-type semiconductor N may be the light emitting element 300-1 that emits red light. In other words, the light emitting element 300-1 having the different arrangement of the P-type semiconductor P and the N-type semiconductor N may be the first light emitting element 300-1 that emits red light.

In addition, at least one of the plurality of light emitting elements 300-1, 300-2, and 300-3 may have a different connection between each of the P-type semiconductor P and the N-type semiconductor N and the upper extension portion 220. For example, the P-type semiconductor P of at least one light emitting element 300-1 of the plurality of light emitting elements 300-1, 300-2, and 300-3 may be directly connected to the upper extension portion 220 through a conductive material or adhesive material, and the N-type semiconductor N may be connected to the upper extension portion 220 through a wire W. In addition, each of the P-type semiconductors P and the N-type semiconductors N in the other light emitting elements 300-2 and 300-3 may be connected to the upper extension portion 220 through a wire W. In this case, the N-type semiconductors N of the other light emitting elements 300-2 and 300-3 may be connected to the upper surface 111 of the base 110 by silicon.

The light emitting element 300-1 having the different connection between each of the P-type semiconductor P and the N-type semiconductor N and the upper extension portion 220 may be the light emitting element 300-1 that emits red light. For example, the light emitting element 300-1 having the different connection between each of the P-type semiconductor P and the N-type semiconductor N and the upper extension portion 220 may be the first light emitting element 300-1 that emits red light.

Among the plurality of light emitting elements 300-1, 300-2, and 300-3, the light emitting elements 300-1 having the different arrangement of the P-type semiconductor P and the N-type semiconductor N and the different connection between each of the P-type semiconductor P and the N-type semiconductor N and the upper extension portion 220 may be a vertical chip. In addition, the light emitting elements 300-2 and 300-3 that are not the vertical chip may be lateral chips. The light emitting elements 300-2 and 300-3, which are lateral chips, may be connected to the upper surface 111 of the base 110 by silicon. For example, the first light emitting element 300-1 that emits red light may be the vertical chip. Further, the second light emitting element 300-2 and the third light emitting element 300-3 may be lateral chips. The second light emitting elements 300-2 and the third light emitting element 300-3, which are lateral chips, may be connected to the upper surface 111 of the base 110 by silicon.

Meanwhile, in addition to such configurations, according to an eighth embodiment of the present disclosure, the module body 100 may further include a side wall portion 120.

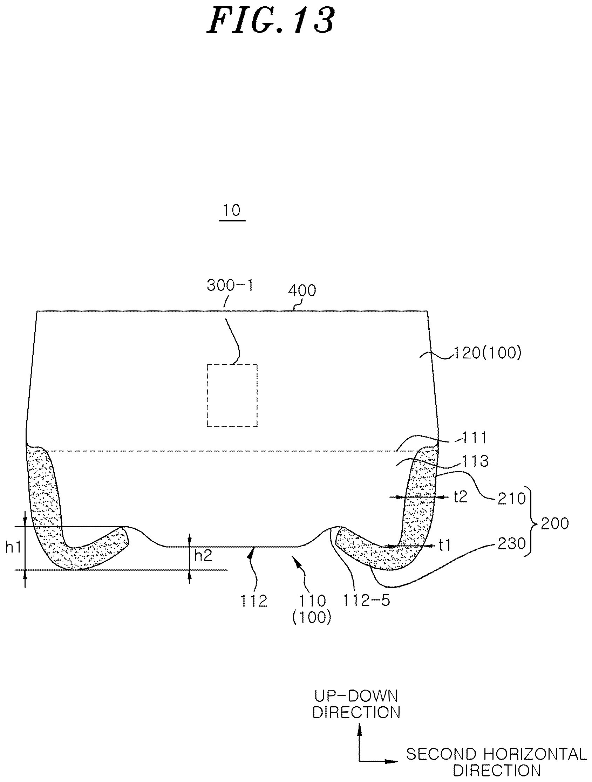

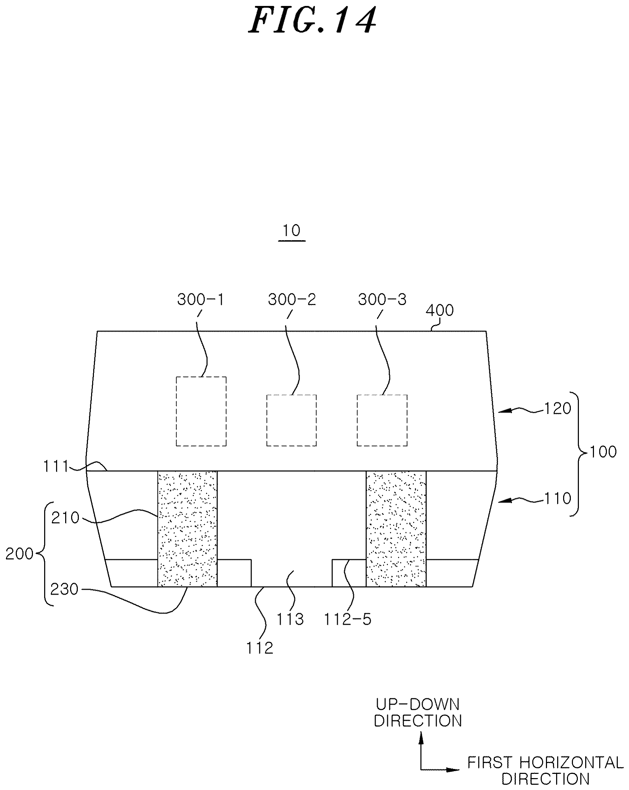

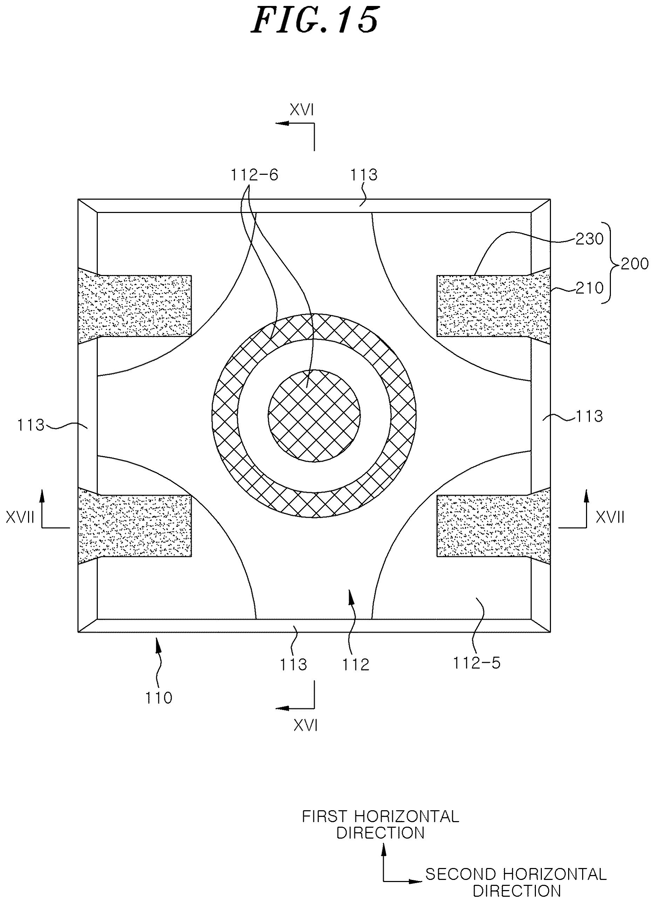

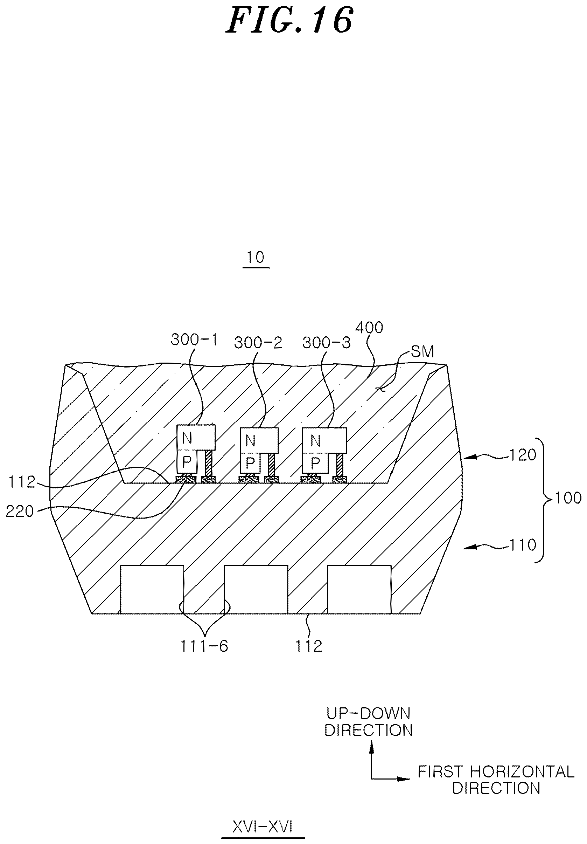

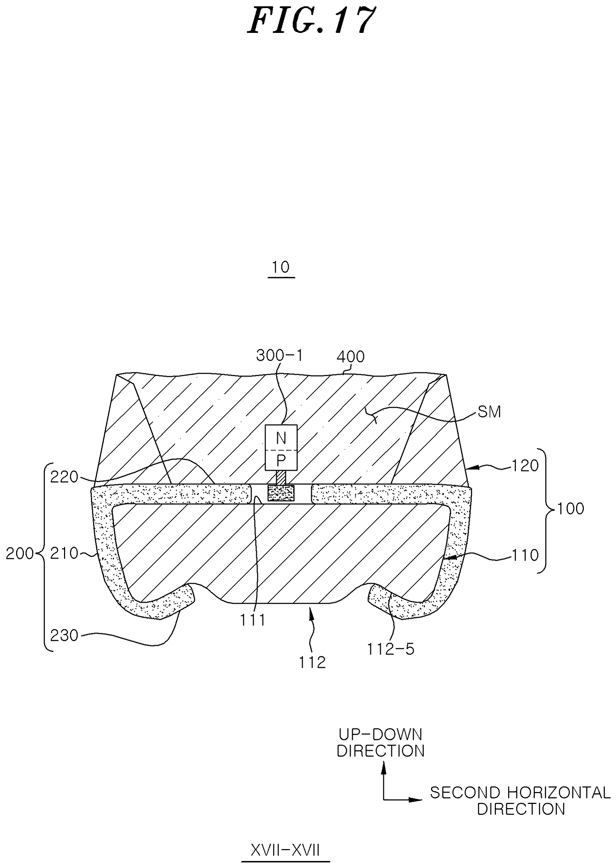

The eighth embodiment will be described with reference to FIGS. 13 to 17. In describing the eighth embodiment of the present disclosure, the differences from the above-described embodiments are mainly explained, and the same description and reference numerals refer to the above-described embodiments.

Referring to FIGS. 13 to 17, the module body 100 may further include the side wall portion 120.

The side wall portion 120 may extend upward from an edge of the upper surface 111 of the base 110. The side wall portion 120 may be integrally formed with the base 110. The sidewall portion 120 may provide a molding filling space SM, in which the plurality of light emitting elements 300-1, 300-2, and 300-3 are disposed and the molding 400 may be filled.

The side wall portion 120 may be inclined so that its thickness in the horizontal direction decreases as it goes upward. In addition, the base 110 may be inclined so that its cross-sectional area in the horizontal direction decreases as it goes downward. Further, when an upper end of the side wall portion 120 is projected directly downward onto a virtual horizontal plane including a lower end of the base 110, the upper end of the side wall portion 120 may surround the lower end of the base 110. In addition, at least a portion of the side wall portion 120 may overlap a portion of the electrode 200 in the up-down direction. For example, at least a portion of the side wall portion 120 may overlap at least a portion of the up-down extension portions 210 of the electrode 200.

An electrode arrangement groove 112-5 may be formed on the lower surface 112 of the base 110. The lower extension portion 230 is disposed in the electrode arrangement groove 112-5, and the electrode arrangement groove 112-5 may be concave toward the center of the base 110 in the horizontal direction. For example, the electrode disposition groove 112-5 may have a fan shape.

The lower extension portion 230 of the electrode 200 may extend to be inclined upward as it goes toward the center of the base 110 in the horizontal direction. In addition, a direct upward distance h1 between the lowermost end of the lower extension portion 230 and the uppermost end of the lower extension portion 230 may be greater than a direct upward distance h2 between the lowermost end of the lower extension portion 230 and the lowermost end of the base 110. Accordingly, the electrode 200 can be firmly disposed on the base 110.

A horizontal thickness t1 of the lowermost end of the up-down extension portion 210 may be smaller than a horizontal thickness t2 at the center of the up-down extension portion 210.

Although the up-down extension portion 210 of the electrode 200 is shown as being in contact with the peripheral surfaces 113, unlike this, the up-down extension portion 210 of the electrode 200 may be spaced apart from the peripheral surfaces 113 to form a space therebetween as an air flow path.

Meanwhile, a flow hole 112-6 may be formed in the lower surface 112 of the base 110. For example, two circular flow holes 112-6 may be concentrically formed at the center of the lower surface 112 of the base 110. Air introduced between the lower surface 112 of the base 110 and the display substrate may flow through the flow holes 112-6. In addition, heat generated by the plurality of light emitting elements 300-1, 300-2, and 300-3, etc. may be cooled by the air flowing through the flow holes 112-6.

In addition, the upper edge of the molding 400 may cover the upper end of the side wall portion 120. In addition, the upper surface of the molding 400 may be uneven. The uneven surface may be formed entirely on the upper surface or may be formed on a partial region of the upper surface. The uneven surface may serve as a microlens. Accordingly, light emitted through the uneven region and light emitted from the other regions may have different beam angles or light intensities.

Meanwhile, in addition to such configurations, according to a ninth embodiment of the present disclosure, the light emitting module 10 may further include a control element 500.

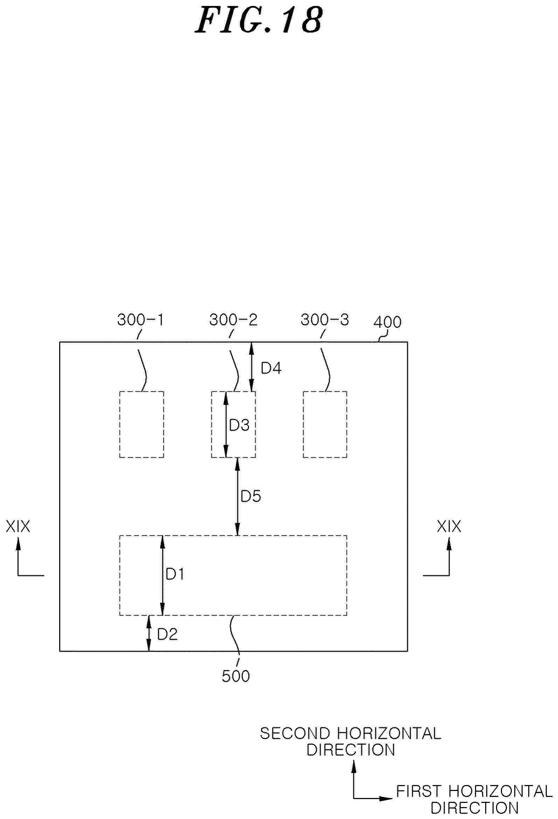

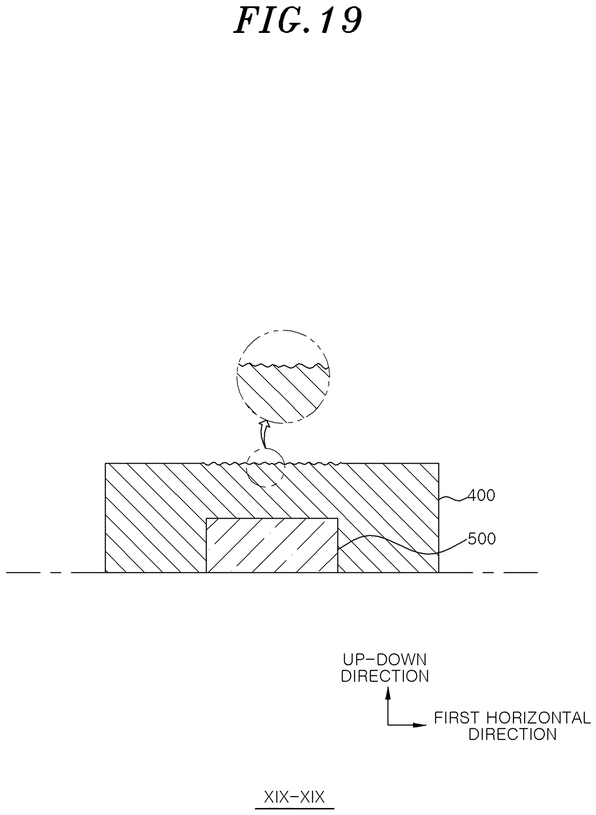

The ninth embodiment will be described with reference to FIGS. 18 and 19. In describing the ninth embodiment of the present disclosure, the differences from the above-described embodiments are mainly explained, and the same description and reference numerals refer to the above-described embodiments.

Referring to FIGS. 18 and 19, the light emitting module 10 may further include a control element 500. The control element 500 is connected to the plurality of light emitting elements 300-1, 300-2, and 300-3 through the plurality of electrodes 200 to control the plurality of light emitting elements 300-1, 300-2, and 300-3. For example, the control element 500 may control the supply or non-supply of electricity to each of the plurality of light emitting elements 300-1, 300-2, and 300-3. In addition, the control element 500 may control the intensity of light emitted from each of the plurality of light emitting elements 300-1, 300-2, and 300-3, and the like.

The control element 500 may be disposed on the base 110 and covered by the molding 400 covering the plurality of light emitting elements 300-1, 300-2, and 300-3. An uneven portion may be formed in an upper surface of the molding 400 directly above the control element 500. Light emitted from the plurality of light emitting elements 300-1, 300-2, and 300-3 may be scattered by the uneven portion in the upper surface of the molding 400 directly above the control element 500. Accordingly, even when the control element 500 is disposed within the molding 400, light emitted from the plurality of light emitting elements 300-1, 300-2, and 300-3 can be emitted to the outside of the molding 400 without being obstructed by the control element 500. The control element 500 is electrically connected to the plurality of light emitting elements 300-1, 300-2 and 300-3 to control each of the plurality of light emitting elements 300-1, 300-2 and 300-3. That is, since the plurality of light emitting elements 300-1, 300-2, and 300-3 controlled by one control element 500 emit different peak wavelengths, various colors can be realized through a combination of these peak wavelengths. The control element 500 may be disposed closer to the side of the base 110 than the center thereof.

In the second horizontal direction, a length D1 of the control element 500 may be greater than a length D3 of at least one light emitting element 300-1, 300-2, or 300-3. In addition, a separation distance D2 between the control element 500 and one side of the base 110 may be less than a separation distance D5 between the at least one light emitting element 300-1, 300-2, or 300-3 and the control element 500. Further, the separation distance D2 between the control element 500 and one side of the base 110 may be less than a separation distance D4 between the at least one light emitting element 300-1, 300-2, or 300-3 and the other side of the base 110. Further, the separation distance D5 between the at least one light emitting element 300-1, 300-2, or 300-3 and the control element 500 may be greater than the length D3 of the at least one light emitting element 300-1, 300-2, or 300-3. Accordingly, the control element 500 is placed close to one side to improve thermal problems, and even when the control element 500 is disposed together with the plurality of light emitting elements 300-1, 300-2, and 300-3, it is possible to prevent the weight from being biased to one side and the light emitting module 10 from being biased upon circuit bonding.

Meanwhile, in addition to such configurations, according to a tenth embodiment of the present disclosure, a partition groove 400-5 may be formed on the upper surface of the molding 400.

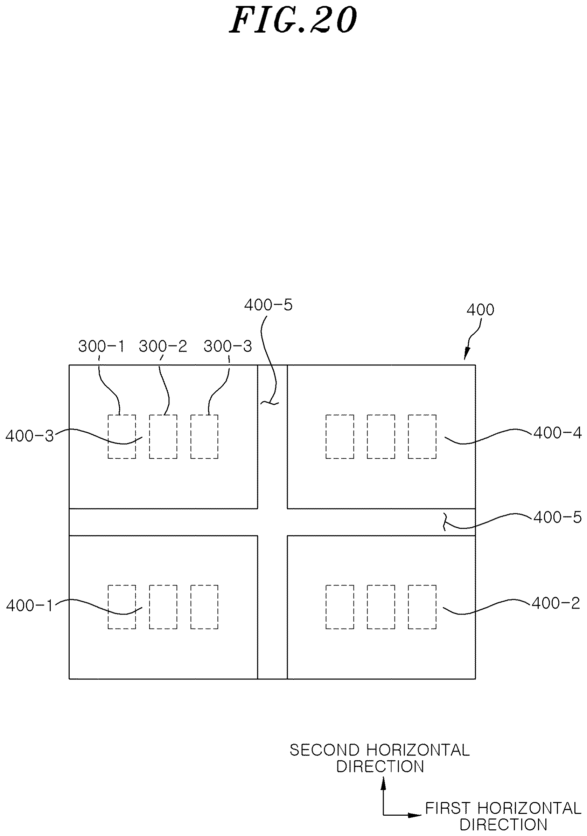

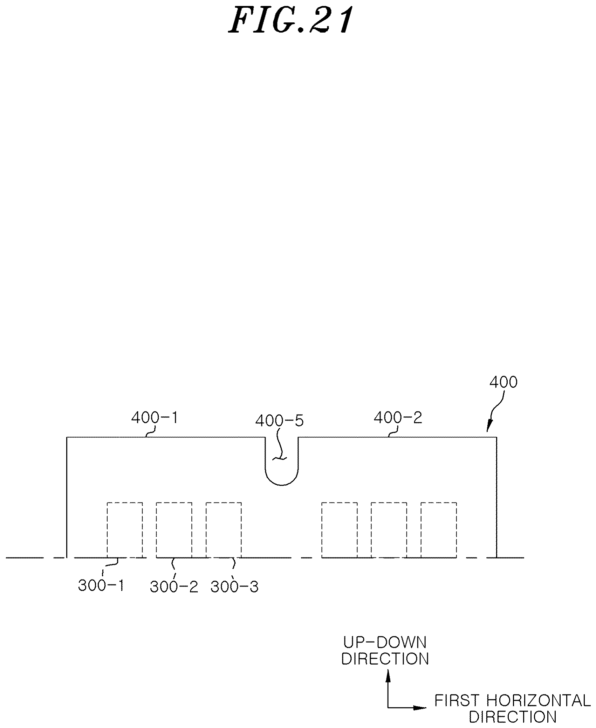

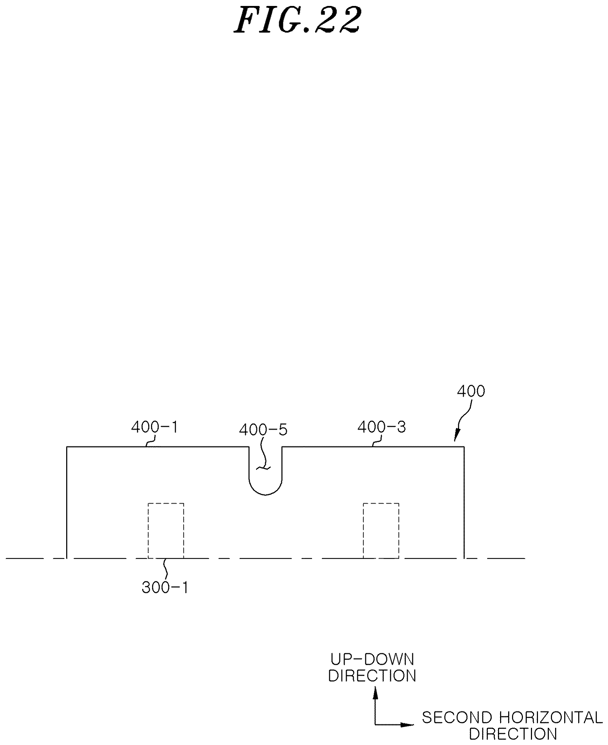

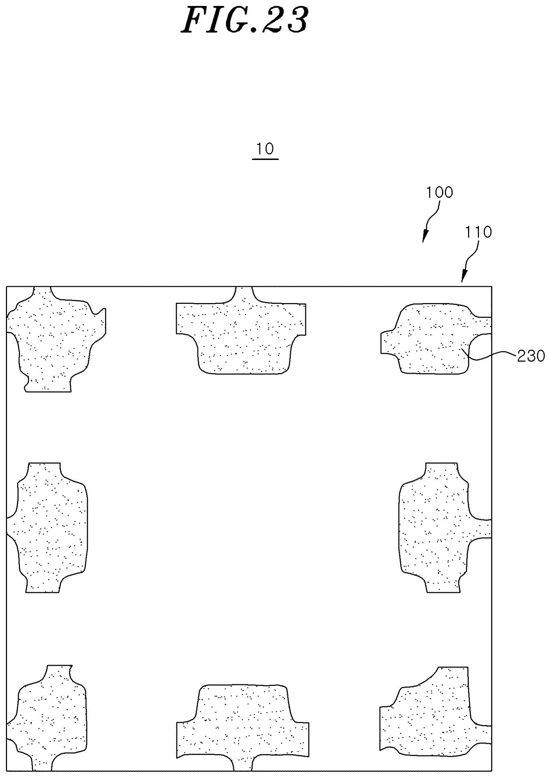

The tenth embodiment will be described with reference to FIGS. 20 to 23. In describing the tenth embodiment of the present disclosure, the differences from the above-described embodiments are mainly described, and the same description and reference numerals refer to the above-described embodiments.

Referring to FIGS. 20 to 23, a partition groove 400-5 may be formed on the upper surface of the molding 400. The partition groove 400-5 may partition the upper portion of the molding 400 into a plurality of light emitting regions 400-1, 400-2, 400-3, and 400-4. For example, the partition groove 400-5 may be formed in a cross shape on the upper surface of the molding 400 to partition the upper portion of the molding 400 into four light emitting regions. In other words, the partition groove 400-5 is formed on the upper surface of the molding 400 in each of a first horizontal direction and a second horizontal direction to divide the upper surface of the molding 400 into four light emitting regions. The plurality of light-emitting regions 400-1, 400-2, 400-3, and 400-4 include a first light-emitting region 400-1, a second light-emitting region 400-2, and a third light-emitting region 400-3, and a fourth light emitting region 400-4. When the partition groove 400-5 is formed in a cross shape on the upper surface of the molding 400, the center of the cross shape formed by the partition groove 400-5 may correspond to the center of the base 110 of the module body 100. Meanwhile, the area of upper surfaces of the light emitting regions 400-1, 400-2, 400-3, and 400-4 may occupy 40% to 49% of the total area of the upper surface of the molding 400.

When viewed in a cross section cut in the vertical direction, the partition groove 400-5 may have two vertical surfaces that are spaced apart from each other and extend in parallel, and a curved surface of a shape concave downward whose upper ends are connected to respective lower ends of the two vertical surfaces. Since the partition groove 400-5 may have a different refractive index, the upper portion of the molding 400 can be partitioned into the plurality of light emitting regions 400-1, 400-2, 400-3, and 400-4.

As described above, when the partition groove 400-5 is formed in each of the first horizontal direction and the second horizontal direction on the upper surface of the molding 400, the two vertical surfaces and the curved surface of the partition groove 400-5 extending in the first horizontal direction may extend in the first horizontal direction. In addition, the two vertical surfaces and the curved surface of the partition groove 400-5 extending in the second horizontal direction may extend in the second horizontal direction. A distance between the two vertical surfaces of the partition groove 400-5 extending in the first horizontal direction may be greater than a distance between the two vertical surfaces of the partition groove 400-5 extending in the second horizontal direction. In other words, the width of the partition groove 400-5 extending in the first horizontal direction may be greater than that of the partition groove 400-5 extending in the second horizontal direction.

Meanwhile, the distance from the lowermost end to the uppermost end of the molding 400 may be referred to as the height of the molding 400. In addition, the lowermost end of the partition groove 400-5 may be located between a point at which the direct downward distance from the uppermost end of the molding 400 is 30% of the height of the molding 400 and a point at which the upward distance from the lowermost end of the molding 400 is 30% of the height of the molding 400.

In each of the plurality of light-emitting regions 430-1, 430-2, 430-4, and 430-4 partitioned in the upper portion of the molding 400 by the partition groove 400-5, a plurality of light-emitting elements 300-1, 300-2, and 300-3 may be disposed. For example, the plurality of light-emitting regions 400-1, 400-2, 400-3, and 400-4 include the first light-emitting region 400-1, the second light-emitting region 400-2, the third light-emitting region 400-3, and the fourth light emitting region 400-4. In addition, a plurality of light emitting elements 300-1, 300-2, and 300-3 may be disposed in the first light emitting region 400-1, and another plurality of light emitting elements 300-1, 300-2, and 300-3 may be disposed in the second light emitting region 400-2. In addition, still another plurality of light emitting elements 300-1, 300-2, and 300-3 may be disposed in the third light emitting region 400-3, and still another plurality of light emitting elements 300-1, 300-2, and 300-3 may be disposed in the fourth light emitting region 400-4. For example, the first light emitting element 300-1, the second light emitting element 300-2, and the third light emitting element 300-3 may be disposed in the first light emitting region 400-1. Further, the first light emitting element 300-1, the second light emitting element 300-2, and the third light emitting element 300-3 may be disposed in the second light emitting region 400-2. Also, the first light emitting element 300-1, the second light emitting element 300-2, and the third light emitting element 300-3 may be disposed in the third light emitting region 400-3. In addition, the first light emitting element 300-1, the second light emitting element 300-2, and the third light emitting element 300-3 may be disposed in the fourth light emitting region 400-4.

Meanwhile, the number of the lower extension portions 230 of the electrode 200 is eight, two lower extension portions 230 may be a common electrode, and six lower extension portions 230 may not be the common electrode. In addition, one of the two surface extensions 230, which are the common electrode, may be connected to all the light emitting elements 300-1, 300-2, and 300-2 in the first light emitting region 400-1 and the third light emitting region 400-3. The other of the two lower surface extensions 230, which are the common electrode, may be connected to all the light emitting elements 300-1, 300-2, and 300-2 in the second light emitting region 400-2 and the fourth light emitting region 400-4. In addition, three lower extension portions 230 among the six lower extension portions 230, which are not the common electrode, may be respectively connected to the light emitting elements 300-1, 300-2, and 300-3 in the first light emitting region 400-1 and the third light emitting region 400-3. In addition, the other three lower extension portions 230 among the six lower extension portions 230, which are not the common electrode, may be respectively connected to the light emitting element 300-1, 300-2, and 300-3 in the second light emitting region 400-2 and the fourth light emitting region 400-4. With such configurations, the number of the electrodes 200 of the light emitting module 10 can be reduced.

Meanwhile, in addition to such configurations, according to eleventh and twelfth embodiments of the present disclosure, the shape of the partition groove 400-5 may be different from those of the above-described embodiments.

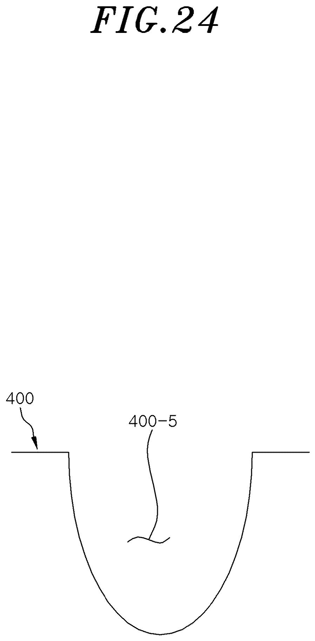

The eleventh embodiment will be described with reference to FIG. 24. In describing the eleventh embodiment of the present disclosure, the differences from the above-described embodiments are mainly explained, and the same description and reference numerals refer to the above-described embodiments.

Referring to FIG. 24, the partition groove 400-5 formed on the upper surface of the molding 400 may be a curved surface depressed formed from the upper surface of the molding 400. For example, the partition groove 400-5 may be a concave paraboloid. Such a paraboloid may be a surface having a parabolic shape when viewed in a cross section cut in a vertical direction.

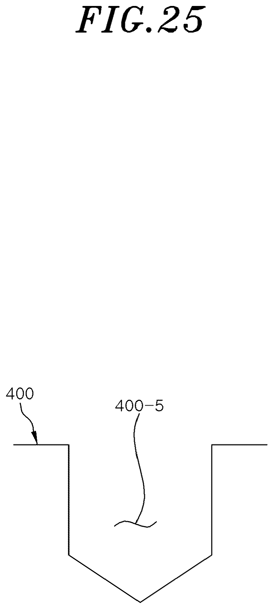

The twelfth embodiment will be described with reference to FIG. 25. In describing the twelfth embodiment of the present disclosure, the differences from the above-described embodiments are mainly explained, and the same description and reference numerals refer to the above-described embodiments.

Referring to FIG. 25, when viewed in a cross section cut in the vertical direction, the partition groove 400-5 formed on the upper surface of the molding 400 may have two vertical surfaces spaced apart from each other and extending in parallel, and two inclined surfaces, upper ends of which are respectively connected to the lower ends of the two vertical surfaces. Lower ends of the two inclined surfaces may be connected to each other to form an edge.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1. A light emitting module, comprising:
a module body including a base having an upper surface, a lower surface, and a plurality of peripheral surfaces connected to the upper surface and the lower surface;
a plurality of electrodes disposed to be exposed to an outside on at least a part of the plurality of peripheral surfaces of the base;
a plurality of light emitting elements disposed on the base to be connected to two or more of the plurality of electrodes; and
a molding covering the plurality of light emitting elements.

2. The light emitting module of claim 1, wherein each of the plurality of electrodes include:
an up-down extension portion disposed to extend in an up-down direction on at least one of the plurality of peripheral surfaces of the base;
an upper extension portion extending from an upper end of the up-down extension portion on the upper surface of the base to be electrically connected to one or more of the plurality of light emitting elements; and
a lower extension portion extending from a lower end of the up-down extension portion on the lower surface of the base.

3. The light emitting module of claim 2, wherein the plurality of peripheral surfaces include:
a plurality of main surfaces having a flat shape; and
a plurality of connecting curved surfaces disposed between neighboring main surfaces among the plurality of main surfaces and having a shape concavely curved toward a center of the base when viewed in the up-down direction,
wherein the plurality of main surfaces and the plurality of connecting curved surfaces are alternately arranged along a circumferential direction,
wherein at least a part of the up-down extension portions is disposed on the connecting curved surface,
wherein the molding includes a main molding covering the upper surface of the base and an electrode molding covering a part of the up-down extension portions, and
wherein a lower part of the electrode molding is formed so that a thickness thereof in a horizontal direction becomes thinner toward the lower side to provide a space portion.

4. The light emitting module of claim 2, wherein the lower surface of the base includes a first opposing side and a second opposing side extending in one direction and opposite to each other,
wherein the plurality of lower extension portions include first lower extension portions extending from the first opposing side and spaced apart from each other in the one direction, and second lower extension portions extending from the second opposing side and spaced apart from each other in the one direction,
wherein a second center line is disposed spaced apart from a first center line in the one direction,
wherein a third center line is disposed spaced apart from the first center line in another direction opposite to the one direction,
wherein the first center line is defined as an imaginary line passing through a center of the first opposing side and a center of the second opposing side,
wherein the second center line is defined as an imaginary line passing through a center between the first lower extension portions, and
wherein the third center line is defined as an imaginary line passing through a center between the second lower extension portions.

5. The light emitting module of claim 4, wherein the lower surface of the base further includes a first neighboring side connected to one end of the first opposing side and one end of the second opposing side, and a second neighboring side connected to the other end of the first opposing side and the other end of the second opposing side, and
wherein one of the first lower extension portions extends to the first neighboring side, or one of the second lower extension portions extends to the second neighboring side.

6. The light emitting module of claim 4, wherein the lower surface of the base further includes a first neighboring side connected to one end of the first opposing side and one end of the second opposing side, and a second neighboring side connected to the other end of the first opposing side and the other end of the second opposing side, and
wherein at least one of the first lower extension portion and the second lower extension portion extends to pass through an imaginary fourth center line passing through a center of the first neighboring side and a center of the second neighboring side.

7. The light emitting module of claim 2, wherein each of the plurality of light emitting elements includes a P-type semiconductor and an N-type semiconductor,
wherein the plurality of light emitting elements have the same arrangement of the P-type semiconductor and the N-type semiconductor, and
wherein the plurality of light emitting elements have the same connection between each of the P-type semiconductor and the N-type semiconductor and the upper extension portion.

8. The light emitting module of claim 2, wherein each of the plurality of light emitting elements includes a P-type semiconductor and an N-type semiconductor,
wherein at least one of the plurality of light emitting elements has a different arrangement of the P-type semiconductor and the N-type semiconductor, and
wherein the plurality of light emitting elements have the same connection between each of the P-type semiconductor and the N-type semiconductor and the upper extension portion.

9. The light emitting module of claim 2, wherein each of the plurality of light emitting elements includes a P-type semiconductor and an N-type semiconductor,
wherein the plurality of light emitting elements have the same arrangement of the P-type semiconductor and the N-type semiconductor, and
wherein at least one of the plurality of light emitting elements has a different connection between each of the P-type semiconductor and the N-type semiconductor and the upper extension portion.

10. The light emitting module of claim 2, wherein each of the plurality of light emitting elements includes a P-type semiconductor and an N-type semiconductor,
wherein at least one of the plurality of light emitting elements has a different arrangement of the P-type semiconductor and the N-type semiconductor, and
wherein at least one of the plurality of light emitting elements has a different connection between each of the P-type semiconductor and the N-type semiconductor and the upper extension portion.

11. The light emitting module of claim 2, wherein the module body further includes a side wall portion extending upward from an edge of the upper surface of the base, and
wherein the side wall portion provides a molding filling space in which the plurality of light emitting elements are disposed and the molding is filled.

12. The light emitting module of claim 11, wherein the side wall portion is inclined so that a thickness thereof in a horizontal direction decreases as it goes upward.

13. The light emitting module of claim 11, wherein the base is inclined so that a cross-sectional area thereof in a horizontal direction decreases as it goes downward.

14. The light emitting module of claim 11, wherein when an upper end of the side wall portion is projected directly downward onto an imaginary horizontal plane including a lower end of the base, the upper end of the side wall portion surrounds the lower end of the base.

15. The light emitting module of claim 11, wherein on the lower surface of the base, an electrode arrangement groove in which the lower extension portion is disposed and which is depressed toward a center of the base in a horizontal direction is formed, and
wherein the lower extension portion extends to be inclined upward toward the center of the base in the horizontal direction.

16. The light emitting module of claim 15, wherein a direct upward distance between the lowermost end of the lower extension portion and the uppermost end of the lower extension portion is greater than a direct upward distance between the lowermost end of the lower extension portion and the lowermost end of the base.

17. The light emitting module of claim 15, wherein a thickness in the horizontal direction of the lowermost end of the up-down extension portion is smaller than a thickness in the horizontal direction at a center of the up-down extension portion.

18. The light emitting module of claim 1, further comprising a control element connected to the plurality of light emitting elements through the plurality of electrodes to control the plurality of light emitting elements,
wherein the control element is disposed on the base and covered by the molding covering the plurality of light emitting elements.

19. A light emitting module, comprising:
a module body including a base having an upper surface, a lower surface, and a plurality of peripheral surfaces connected to the upper surface and the lower surface;
a plurality of electrodes disposed to be exposed to an outside on at least a part of the plurality of peripheral surfaces of the base;
a plurality of light emitting elements disposed on the base to be connected to two or more of the plurality of electrodes; and
a molding covering the plurality of light emitting elements,
wherein a partition groove is formed on an upper surface of the molding to partition an upper part of the molding into a plurality of light emitting regions, and
wherein the plurality of light-emitting devices are disposed in each of the plurality of light-emitting regions.

20. A display device, comprising:
a display substrate on which an electric circuit is disposed;
a plurality of light emitting modules disposed on the display substrate to be electrically connected to the electric circuit,
wherein the light emitting module includes:
a module body including a base having an upper surface, a lower surface, and a plurality of peripheral surfaces connected to the upper surface and the lower surface;
a plurality of electrodes disposed to be exposed to the outside on at least a part of the plurality of peripheral surfaces of the base;
a plurality of light emitting elements disposed on the base to be connected to two or more of the plurality of electrodes; and
a molding covering the plurality of light emitting elements.
